# EUROPEAN PATENT APPLICATION

(11) **EP 3 104 334 A1**
(43) Date of publication of application: **14.12.2016**
(21) Application number: 16173348.0
(22) Date of filing: 07.06.2016
(51) Int. Cl.: G06T 17/20, G06F 17/50

(54) **ANALYTICAL MESH GENERATION DEVICE AND METHOD**

(30) Priority: 08.06.2015 JP 2015115539
(71) Applicant: Hitachi, Ltd., Tokyo 100-8280 (JP)
(72) Inventor: HARIYA, Masayuki, Tokyo, 100-8280 (JP); ONODERA, Makoto, Tokyo, 100-8280 (JP); HIRO, Yoshimitsu, Tokyo, 100-8280 (JP); KONGOU, Chikara, Tokyo, 100-8280 (JP); SHINTANI, Masaki, Tokyo, 100-8280 (JP); UTSUNOMIYA, Tomoaki, Saitama, 351-0193 (JP); TSUKAMOTO, Mamoru, Saitama, 351-0193 (JP); EGUCHI, Hisayuki, Saitama, 351-0193 (JP)
(74) Representative: MERH-IP Matias Erny Reichl Hoffmann Patentanwälte PartG mbB

(57) **Abstract**

An analytical mesh generation device (100) includes a shape model input unit (102) for inputting a shape model of an analytical subject, a mesh size input unit (103) for inputting a size of a hexahedral mesh to be generated, a mesh generation region extraction unit (104) for extracting a mesh generation region for generating the hexahedral mesh from the shape model using the mesh size (D4), and a hexahedral mesh generation unit (105) for generating the hexahedral mesh for the extracted mesh generation region.

## Description

### BACKGROUND OF THE INVENTION

### (1) Field of the Invention

The present invention relates to an analytical mesh generation device and an analytical mesh generation method employed for numerical simulation. More specifically, the present invention relates to the analytical mesh generation device and the method for generating the hexahedral mesh suitable for analysis of the problem of large deformation such as deformation problem of rubber parts.

### (2) Description of the Related Art

The recent efforts increasingly made by manufacturing industries have adopted the numerical simulation such as finite element method in the stage of product development and design for estimating the stress and deformation expected to be applied to the product in advance so as to reduce the number of times of prototype manufacturing.

In most cases, the polyhedral mesh set called analytical mesh has to be generated for the calculation region so as to perform the numerical simulation. The hexahedral mesh or tetrahedral mesh has been mainly employed for the three-dimensional analysis region. The hexahedral mesh has been employed more than the tetrahedral mesh to cope with the analysis problem with high non-linearity such as the contact problem and the large deformation problem because of higher precision in general, and better mesh shape controllability compared with the tetrahedral mesh.

In the case of the large deformation problem, the mesh with small size will be crushed to cause the divergent state where the analytical calculation cannot be conducted in the normal state. Upon deformation analysis of the rubber product, for example, the mesh size has to be determined in accordance with the deformation amount per unit time. The mesh size has to be made large in accordance with the large deformation amount, otherwise the model will collapse, disabling calculation. It is therefore preferable to allow the mesh to be large-sized to a certain degree for the time necessary for the calculation as short as possible.

Before generation of the hexahedral mesh, it is preferable to eliminate a very small part from the analysis region, which will be less influential to the overall deformation thereof through the shape simplification process. However, it is necessary to execute the shape simplification process by a skilled analyst interactively based on his/her knowledge, requiring time and labor.

Japanese Patent Application Laid-Open No. 2004-32473 discloses the information processing device and the method thereof, configured so that an initial mesh model representing the surface shape of the three-dimensional model produced by CAD is generated so as to provide the analytical model with simplified shape by subjecting the initial mesh model to the edge collapse process for a predetermined number of times.

Patent Document 1: Japanese Patent Application Laid-Open No. 2004-32473

Referring to the device and method as disclosed in Japanese Patent Application Laid-Open No. 2004-32473, the tetrahedral mesh is deformed through the edge collapse process so as to be converted into the one with the size larger than the initial mesh. In expectation of the shape shift amount from the initial mesh on the shape surface, the mesh deformation process is executed so as to lessen the shape shift amount. The aforementioned device and method are designed to execute the simplification process to increase the mesh size while keeping the original analysis region. General structural analysis and fluid analysis require the analytical mesh which keeps its original shape as much as possible. The disclosed device and method provide the aforementioned analytical mesh effectively.

The aforementioned method, however, cannot be applied to the shape simplification process required to delete a part of the analysis region for coping with the large deformation problem.

The present invention provides the mesh generation device and method for generating especially the hexahedral mesh with a size equal to or larger than the specified one for coping with the large deformation problem through the simplification process which allows deletion of the very small part from the analysis region, which is less influential to the overall deformation from the analytical area.

### SUMMARY OF THE INVENTION

The analytical mesh generation device according to the present invention includes a shape model input unit for inputting a shape model of an analytical subject, a mesh size input unit for inputting a size of a hexahedral mesh to be generated, a mesh generation region extraction unit for extracting a mesh generation region for generating the hexahedral mesh from the shape model using the mesh size, and/or a hexahedral mesh generation unit for generating the hexahedral mesh for the extracted mesh generation region.

The analytical mesh generation method according to the present invention includes the steps of holding a shape model of an analytical subject and a mesh size of a hexahedral mesh to be generated, extracting a mesh generation region for generating the hexahedral mesh from the shape model using the mesh size, and generating the hexahedral mesh for the extracted mesh generation region.

The present invention is capable of generating the hexahedral mesh for a large deformation analysis without executing the shape simplification process, resulting in highly efficient analytical operation.

### BRIEF DESCRIPTION OF THE DRAINWGS

Fig. 1 is a view representing an exemplary system structure of an analytical mesh generation device 100 according to an embodiment;
Figs. 2A to 2E represent the mesh generation flow;
Fig. 3 is a view representing an exemplary display on a monitor screen with an input/output section I/O;
Fig. 4 is a view representing an exemplary display on the monitor screen with the input/output section I/O;
Fig. 5 is a flowchart of process steps of a mesh generation region extraction section;
Fig. 6 is a view representing an example of a shape rough division process;
Fig. 7 is a view representing a tetrahedral mesh deletion process;
Fig. 8 is a view representing an example of the mesh generation region;
Fig. 9 is a flowchart of process steps of a mesh generation region extraction section according to a second embodiment;
Fig. 10 is a view representing an example of a hexahedral mesh deletion process; and
Fig. 11 is a view representing an example of a hexahedral mesh correction process.

### DETAILED DESCRIPTION OF THE PREFERRED EMBODIMENTS

Embodiments according to the present invention will be described in detail referring to the drawings.

### First Embodiment

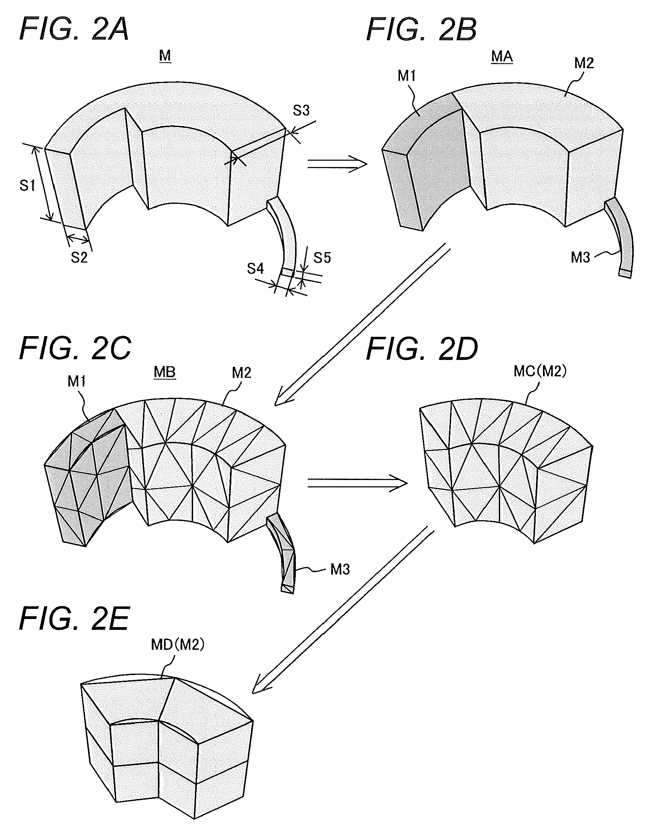

In this embodiment, the analytical mesh generation device and method will be explained with respect to generation of the hexahedral mesh for large deformation analysis, taking a shape model M shown in Figs. 2A to 2E as an example.

It is assumed that the respective parts of the shape model M as shown in Fig. 2A have dimensions S1 (10 mm) and S5 (1 mm) each as height, and S2 (2 mm), S3 (5 mm), and S4 (1 mm) each as width, respectively. The following explanation will be made on the assumption that the hexahedral mesh to be generated has the size set to 3 mm or larger.

Upon generation of the analytical mesh by means of the analytical mesh generation device according to the embodiment, the shape model M is divided into partial region shape models M1, M2, M3 which constitute a shape model MA with different brightness from that of the shape model M as shown in Fig. 2B. The partial region shape model M1 has a height S1 (10 mm) and width S2 (2 mm). The partial region shape model M2 has a height S1 (10 mm) and width S3 (5 mm). The partial region shape model M3 has a height S5 (1 mm) and width S4 (1 mm). In this embodiment, the shape models MA including the partial region shape models M1, M2, M3 may be arbitrarily expressed by, for example, coordinates, dimensions, and angles, which are not limited thereto. CAD data may be used as those for expression of the models.

Referring to Fig. 2C, the analytical mesh generation device and method according to the embodiment serve to generate a tetrahedral mesh shape model MB which expresses the partial region shape models M1, M2, M3 with the tetrahedral mesh.

Fig. 2D shows an extracted tetrahedral mesh shape model MC representing mesh generation region derived from deleting the tetrahedral mesh smaller than the size of the hexahedral mesh to be generated. The tetrahedral mesh shape model MC corresponds to the partial region shape model M2. In the process, the partial region shape models M1 and M3 are deleted each as the tetrahedral mesh which is smaller than the hexahedral mesh size. As a result, the shape model M with originally complicated shape is reexpressed as the simplified model containing only the partial region shape model M2 expressed by the tetrahedral mesh.

The thus extracted mesh generation region M2 does not contain detailed parts M1 and M3 of the shape model. It is therefore possible to automatically generate a hexahedral mesh shape model MD (M2) which keeps the mesh size suitable for the large deformation analysis.

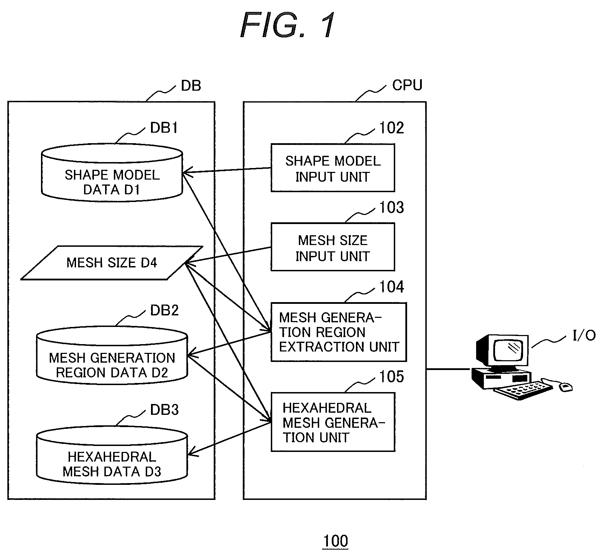

Fig. 1 shows an exemplary system structure of an analytical mesh generation device 100 according to a first embodiment. The analytical mesh generation device 100 of the first embodiment is mainly constituted by a storage section DB, an input/output section I/O, and an operation section CPU. The input/output section I/O includes a keyboard, a mouse, a display and the like for inputting data, and displaying the input data and the analytical mesh on the screen.

The operation section CPU is constituted by a computer, and the storage section DB is an external storage device of the computer. The storage section DB includes a shape model data storage section DB1 which stores the shape model data D1 of the analytical subject, a mesh generation region data storage section DB2 which stores the mesh generation region data D2 indicating the region for generating the hexahedral mesh, and a hexahedral mesh data storage section DB3 which generates the hexahedral mesh data D3. The storage section DB contains size data D4 for designation of size of the hexahedral mesh to be generated. The storage section DB is formed as the external storage device of the computer. Alternatively, it may be structured as an internal storage section installed in the computer.

The operation section CPU includes a shape model input section 102 which receives the shape model data D1 of the analytical subject through the input/output section I/O so as to be stored in the shape model data storage section DB1, a mesh size input section 103 which receives the size data D4 of the hexahedral mesh to be generated through the input/output section I/O so as to be stored in the storage section DB, a mesh generation region extraction section 104 which receives the shape model data D1 from the shape model data storage section DB1, and the size data D4 of the hexahedral mesh from the storage section DB so as to extract the mesh generation region data D2 as the region for generating the hexahedral mesh, and a hexahedral mesh generation section 105 which receives the mesh generation region data D2 from the mesh generation region data storage section DB2, and the size data D4 of the hexahedral mesh from the storage section DB so as to generate the hexahedral mesh data D3, which constitute an inner processing function section.

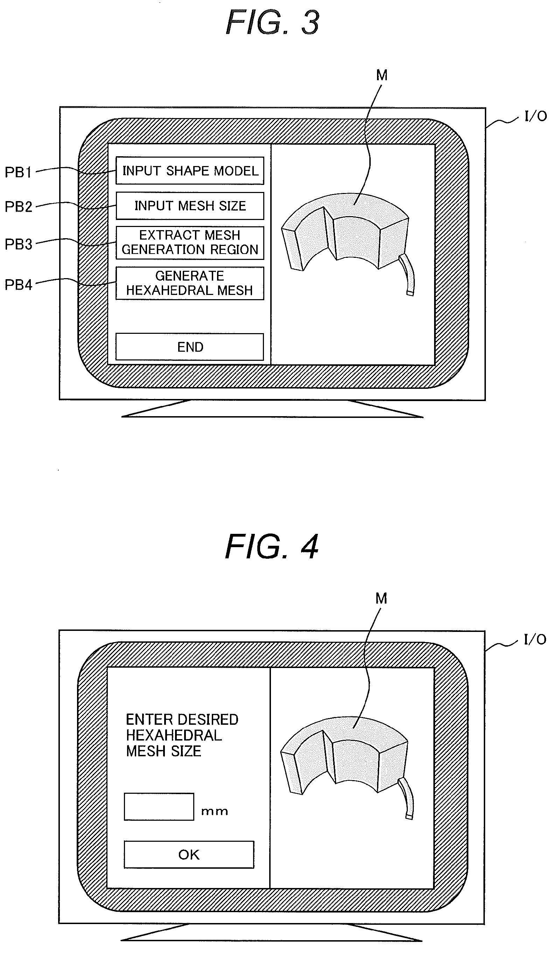

Fig. 3 is a view representing an exemplary display on the monitor screen of the input/output section I/O. On the monitor screen, the shape model M of the analytical subject and a plurality of buttons PB are displayed. Upon selection of the buttons PB1 to PB4, the shape model input section 102, the mesh size input section 103, the mesh generation region extraction section 104, and the hexahedral mesh generation section 105 are activated, respectively. In this embodiment, it is assumed that selection of the button PB activates the corresponding processing section. As the procedure of the mesh generation has been determined, the device may be configured to allow consecutive operations of the shape model input section 102, the mesh size input section 103, the mesh generation region extraction section 104, and the hexahedral mesh generation section 105 in sequence. The specific process steps of the respective sections of the operation section CPU will be described in detail.

### (1) Shape model input section 102

The shape model input section 102 generates and changes the shape model data D1 in accordance with requests of generation and change of the shape model M which has been input by a system user through the keyboard and the mouse of the input/output device I/O.

The boundary representation may be used for expressing the shape model data D1. The boundary representation serves to express the three-dimensional object by the boundary surface between the outer side and the inner side. The shape model data D1 include phase (topology) data expressing connection of the boundary surfaces, and geometric data (geometry) expressing the boundary surface shape. The boundary representation takes the data structure in which the three-dimensional object has a set of at least one continuous attributed boundary surface, the surface has at least one attributed line segment, and the line segment has a starting point and an end point. The point has a three-dimensional coordinate values as the geometric data. Arbitrary types of methods for representing the geometric data with respect to the line and surface may be employed. In this embodiment, NURBS function which has been widely used for the geometric data representation by the three-dimensional CAD will be employed. The literature titled "Basics and application of three-dimensional CAD" (H. Toriya, H. Chiyokura, Kyoritsu Shuppan Co., Ltd., 1991) discloses the boundary representation in detail.

The input shape model data D1 may be arranged on the shape model data storage section DB1 which stores the shape model data D1 of the analytical subject so as to be accessible for reference in the subsequent mesh generation operation.

### (2) Mesh size input section 103

The mesh size input section 103 demands the system user to input the mesh size to be generated in reference to the displayed monitor screen as shown in Fig. 4. The system user inputs the mesh size using the keyboard and the mouse of the input/output device I/O. The input mesh size is arranged on the storage section DB as the size data D4 for designating the size of the hexahedral mesh to be generated so that it is accessible for reference in the subsequent mesh generation operation. In this embodiment, 3 mm is input as the mesh size.

### (3) Mesh generation region extraction section 104

The mesh generation region input section 104 obtains the shape model data D1 of the analytical subject and the mesh size D4 in reference to the storage section DB, and outputs the mesh generation region data D2 as the processing results. The mesh generation region data D2 are arranged on the hexahedral mesh data storage section DB3 so as to be kept accessible for reference in the subsequent mesh generation operation.

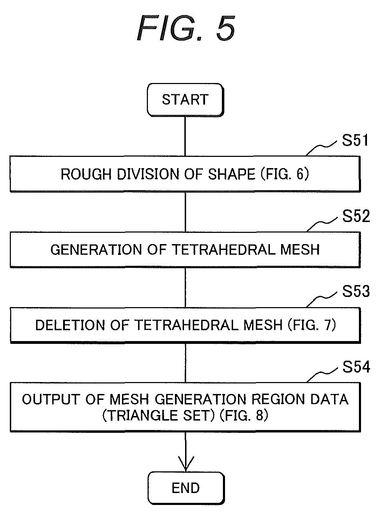

Fig. 5 represents the flow of process steps of the mesh generation region extraction section 104. The process steps will be described in detail by following the flow. In step S51, the shape model data D1 of the analytical subject are read to perform rough division of the shape. The rough division refers to the process for dividing the shape model M into a plurality of models M1, M2 and M3 each representing the partial shape. This process step is effective for simplifying the region to be extracted as the mesh generation region so that the hexahedral mesh is easily generated.

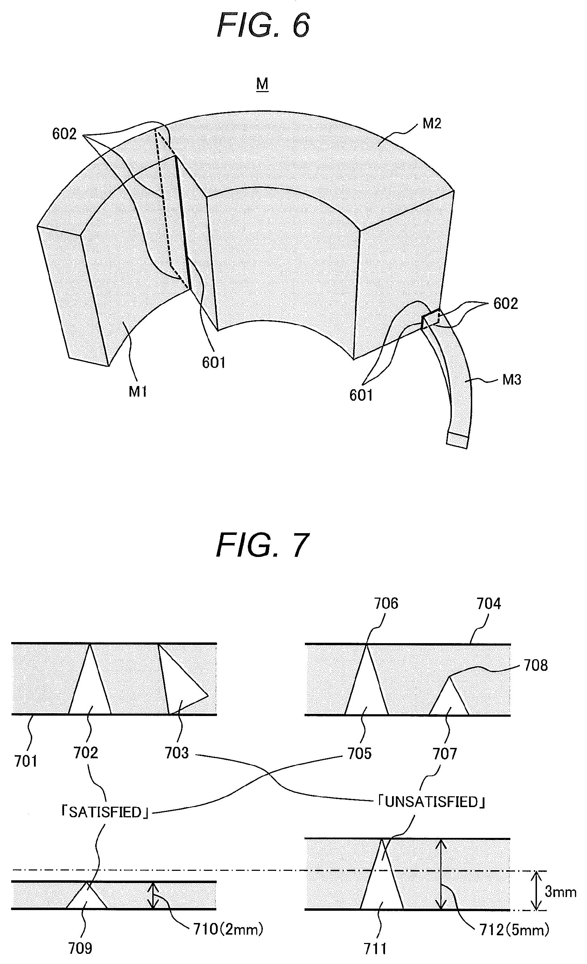

An example of the shape division will be described referring to Fig. 6. The rough division is conducted to divide the model M shown in Fig. 2A into the division models M1, M2 and M3 shown in Fig. 2B. Specifically, the rough division may be conducted by repeatedly executing the following steps from S511 to S514 which constitute step S51.
Step S511: Based on the normal direction of the surface that constitutes the shape model M, sizes of absolute values of components of the unit normal vector are compared. The axial direction with the largest absolute value is set as the representative axial direction of the subject surface.
Step S512: The common line of the surface in the different representative axial direction, which forms a concave connection to the surface at the common line position is extracted as a division reference line 601 (indicated by bold line). Referring to Fig. 6, two division reference lines 601 are extracted.
Step S513: A starting point is set to one end of the division reference line, and an end point is set to the other end so that the path for the shortest route formed by connecting the starting point and the end point is obtained on the surface of the shape model. A division line 602 that follows the path is generated. Referring to Fig. 6, two division lines 602 are generated.
Step S514: The surface having the division line 602 connected to the division reference line 601 saving as the boundary is generated to divide the shape model M. Referring to Fig. 6, the model is divided into partial shapes M1, M2, and M3 as three convex bodies.

The division surface is generated through the procedure from steps S511 to S514 for performing the rough division of the shape model M. Another method may also be employed as long as the shape model M is divided into convex bodies. The thus obtained division models M1, M2, M3 do not have to be the set of the complete convex bodies. The mesh generation region may be extracted in the subsequent process even if the body has shape including the concave part.

Referring to the process flow shown in Fig. 5, in step S52, the tetrahedral mesh is generated. Generation of the tetrahedral mesh refers to the process of generating the tetrahedral mesh model MB as shown in Fig. 2C from the division models MA (M1, M2, M3) as shown in Fig. 2B. The mesh size to be generated has the value at least larger than the mesh size input through the mesh size input section 103.

In step S53 of the flowchart in Fig. 5, the mesh with a height equal to or smaller than the mesh size is deleted from the generated tetrahedral mesh. The "deletion of the mesh equal to or smaller than the mesh size" refers to the process of obtaining the model MC with the region as shown in Fig. 2D from the tetrahedral mesh model MB as shown in Fig. 2C. The tetrahedral mesh set remained after execution of the process executed in step S53 is determined as the region which allows generation of the hexahedral mesh with the size equal to or larger than the mesh size input through the mesh size input section 103, and becomes the mesh generation region data D2.

The tetrahedral mesh to be deleted in the process executed in step S53 is assumed to satisfy the following three conditions. Fig. 7 shows an example of satisfied and unsatisfied states with respect to the following conditions. Fig. 7 shows the two-dimensional triangle mesh for simplicity.

First condition for deleting tetrahedral mesh: At least one element surface (a side of the element represented by the triangle mesh) exists on a shape surface 701. Referring to Fig. 7, a triangle mesh 702 satisfies the deletion condition as one side of the triangle positioned on the shape surface 701. A triangle mesh 703 does not satisfy the condition as any side of the triangle does not exist on the shape surface 701.

Second condition for deleting tetrahedral mesh: A node (apex of the element represented by the triangle mesh) which is not attributed to the element surface located on the shape surface exists on a shape surface 704. Referring to Fig. 7, a triangle mesh 705 satisfies the deletion condition as a node 706 of the triangle exists on the shape surface 704. A triangle mesh 707 does not satisfy the condition as a node 708 of the triangle is not located on the shape surface 704.

Third condition for deleting tetrahedral mesh: The distance between the mesh surface on the shape surface and the node is equal to or smaller than the mesh size input through the mesh size input section 103. Referring to Fig. 7, a triangle mesh 709 having a height 710 of 2 mm which is smaller than the reference mesh size of 3 mm satisfies the condition. A triangle mesh 711 having a height 712 of 5 mm fails to satisfy the condition because the height is larger than 3 mm.

In step S54 as shown in Fig. 5, the triangle element surface (attributed only to the single tetrahedron) positioned on the surface of the tetrahedral mesh which has been remained after execution of step S53 is output as the mesh generation region data D2.

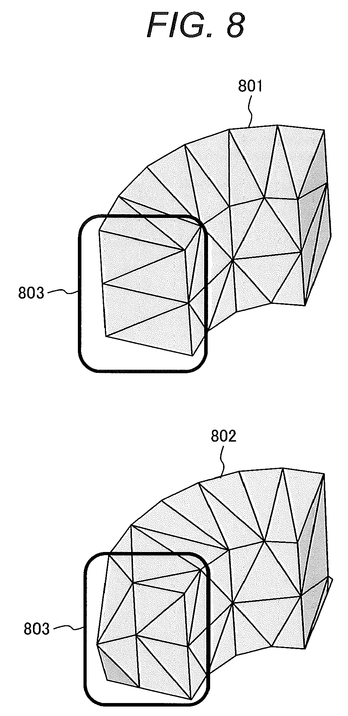

Fig. 8 is a view showing an example of the mesh generation region data. A mesh generation region 801 is obtained as a result of executing the rough division of the shape in step S51, and a mesh generation region 802 is obtained in the case where the rough division of the shape is not executed. The region 801 has a surface shape 803 derived from deleting the mesh, which is more simplified compared with the region 802.

### (4) Hexahedral mesh generation section 105

The hexahedral mesh generation section 105 generates the hexahedral mesh for the mesh generation region data D2 output from the mesh generation region extraction section 104 based on the mesh size D4 input through the mesh size input section 103.

Arbitrary method may be employed for generating the hexahedral mesh. It is possible to automatically generate the hexahedral mesh for the mesh generation region D2 defined as the triangle set through the method disclosed in Japanese Patent Application Laid-Open No. 2002-245098, and the literature titled "Automatic hexahedral mesh generation system using feature line extraction technique" (Proceedings of the Japan Society of Mechanical Engineers, issue 71, No. 701, edition A, pp. 9-15). A hexahedral mesh 205 may be automatically generated for a mesh generation region 204 as shown in Figs. 2A to 2E.

As described above, the first embodiment of the present invention allows automatic extraction of the analytical mesh generation region from the analytical subject shape model. It is possible to automatically generate the hexahedral mesh with a size equal to or larger than the specified size in the end. This makes it possible to execute the analytical mesh generation operation conventionally demanding time and labor with higher efficiency.

### Second Embodiment

The system structure of the analytical mesh generation device according to a second embodiment is similar to that of the analytical mesh generation device of the first embodiment. This embodiment describes use of the hexahedral mesh generated by the mesh generation region extraction section 104.

In the first embodiment, the tetrahedral mesh is generated first, and in the second embodiment, the hexahedral mesh is generated first. In other words, the first and the second embodiment describe generation of the polyhedral mesh which is exemplified by the tetrahedral mesh and the hexahedral mesh, respectively. The effects derived from the mesh generation region extraction section 104 and the hexahedral mesh generation section 105 become different from each other. Accordingly, the different feature will only be described.

### (3) Mesh generation region extraction section 104

The mesh generation region extraction section 104 according to the second embodiment receives the shape model data D1 of the analytical subject, and the mesh size D4, and outputs the hexahedral mesh as the mesh generation region data D2.

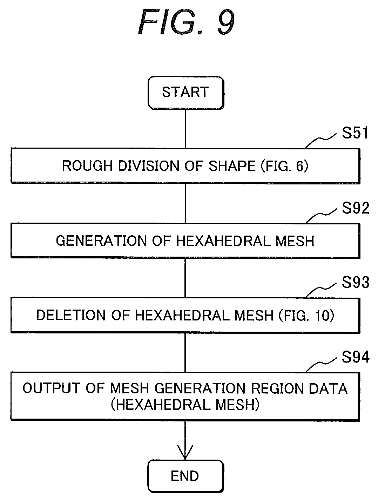

Fig. 9 is a flowchart of process steps of the mesh generation region extraction section 104 according to the second embodiment. The explanation of step S51 which is the same as that of the first embodiment will be omitted.

Referring to the process flow according to the second embodiment, in step S92, the hexahedral mesh is generated for the shape model M or those M1, M2, M3 derived from rough division. In the first embodiment, the tetrahedral mesh is generated first as shown in Fig. 5. In the second embodiment, the hexahedral mesh is generated from the beginning.

The hexahedral mesh may be generated through arbitrary method. For example, it is possible to automatically generate the hexahedral mesh by subjecting the triangle mesh generated for the shape model M to the process as disclosed in Japanese Patent Application Laid-Open No. 2002-245098, and the literature titled "Automatic hexahedral mesh generation system using feature line extraction technique" (Proceedings of The Japan Society of Mechanical Engineers, issue 71, No. 701, edition A, pp. 9-15).

In the next step S93, the mesh with a thickness equal to or smaller than the mesh size is deleted from the generated hexahedral mesh. The mesh thickness is defined as the minimum distance between the reference element surface and the element surface on the shape surface derived from sequential search of the opposing surface of the hexahedral mesh until it reaches the element surface on the shape surface by taking the element surface of the hexahedral mesh on the shape surface as the reference (reference element surface).

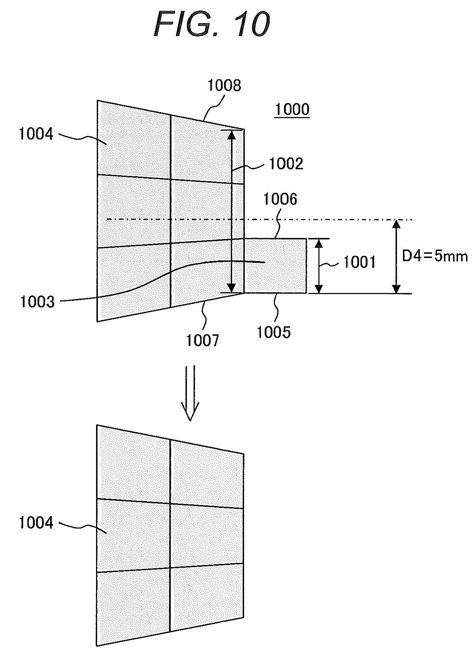

Fig. 10 is a view of the hexahedral mesh seen from the vertical direction. A hexahedral mesh 1000 as the subject is constituted by hexahedral meshes 1003 and 1004. In this embodiment, an element surface 1006 is searched with respect to a reference element surface 1005 of the hexahedral mesh 1003. An element surface 1008 is searched with respect to a reference element surface 1007 of the hexahedral mesh 1004. It is assumed that the minimum distance between the reference element surface 1005 and the element surface 1006 of the hexahedral mesh 1003 corresponds to a distance 1001 which is set to 4.4 mm. It is also assumed that the minimum distance between the reference element surface 1007 and the element surface 1008 corresponds to a distance 1002 which is set to 13.2 mm.

In the aforementioned example, it is assumed that the mesh size D4 input through the mesh size input section 103 is 5 mm. In this case, the mesh having the element thickness of 5 mm or smaller will be deleted. The hexahedral mesh subjected to the search from the reference element surface 1005 to the element surface 1006 of the hexahedral mesh 1003 is expected to be deleted. That is, the hexahedral mesh 1003 is deleted. As the search distance from the reference element surface 1007 to the element surface 1008 is 5 mm or longer, the hexahedral mesh 1004 is not deleted. As a result, only the hexahedral mesh 1004 is obtained. The model constituted by the hexahedral meshes 1003 and 1004 is regenerated as the simplified model constituted only by the hexahedral mesh 1004.

The hexahedral mesh set remained after execution of the aforementioned process is determined as the region which allows generation of the hexahedral mesh with a size equal to or larger than the mesh size input through the mesh size input section 103, and set as the mesh generation region data D2.

In step S94, the hexahedral mesh remained after execution of the process in step S53 is output as the mesh generation region data D2.

### (4) Hexahedral mesh generation section 105

The hexahedral mesh generation section 105 as shown in Fig. 1 corrects the hexahedral mesh with a size equal to or smaller than the mesh size D4 input through the mesh size input section 103 for the mesh generation region data (hexahedral mesh) D2 output from the mesh generation region extraction section 104.

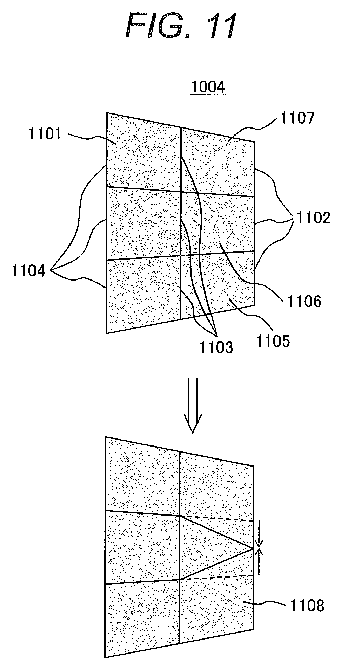

The hexahedral mesh 1004 as shown in Fig. 11 is registered as the mesh generation region data D2 as a result of the hexahedral mesh deleting process as shown in Fig. 10. It is assumed that the mesh has the length of the element side 1102 set to 4.4 mm, the length 1103 of the element side set to 5.2 mm, and the length 1104 of the element side set to 6 mm. The respective lengths 1102, 1103, 1104 of the element sides are compared with 5 mm as the input mesh size.

Only the length 1102 of the element side is smaller than 5 mm, and the lengths 1103 and 1104 are longer than 5 mm. In this case, the length 1102 of the element side is designated as the subject. The element surface of the mesh including any of a plurality of lengths 1102 is subjected to degradation to generate the prism mesh so that the length of the element side is longer than the mesh size of 5 mm.

In this embodiment, three meshes are shown as a plurality of element side lengths 1102. The correction is made by selecting the center mesh preferentially rather than the one at the end so that the element side to be generated resulting from degradation of the element surface is positioned at the center. As a result, the mesh is corrected to the one as indicated by 1108. The element side length of the part, which has been measured 4.4 mm before correction, becomes 6.6 mm. It is possible to generate the hexahedral mesh with a size equal to or larger than the mesh size D4. In the case where there is only the mesh located at the end, degradation of the element surface is conducted so that the element side that is not located at the end is coincided with the end. This makes it possible to generate the hexahedral mesh with a size equal to or larger than the mesh size D4.

According to the second embodiment of the present invention, the region where the mesh smaller than the specified size is generated may be deleted from the hexahedral mesh generated for the analytical subject shape model. The function for correcting the mesh to be equal to or smaller than the specified size may also be added. This finally makes it possible to automatically generate the hexahedral mesh with a size equal to or larger than the specified size. As a result, the analytical mesh generation conventionally demanding time and labor may be conducted with higher efficiency.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

### Reference Signs List

I/O: input/output device
CPU: operation section
DB: storage section
102: shape model input section
103: mesh size input section
104: mesh generation region extraction section
105: hexahedral mesh generation section
D1: shape model data
D2: mesh generation region data
D3: hexahedral mesh data
D4: mesh size
DB1: shape model data storage section
DB2: mesh generation region data storage section
DB3: hexahedral mesh data storage section
M: shape model of analytical subject
MA: rough-division shape model
M1, M2, M3: divided partial shape
MB: tetrahedral mesh
MC: mesh generation region
MD: hexahedral mesh shape model
PB1: button for shape model input
PB2: button for mesh size input
PB3: button for mesh generation region extraction
PB4: button for hexahedral mesh generation
S51: shape rough division process
S52: tetrahedral mesh generation process
S53: tetrahedral mesh deletion process
S54: mesh generation region data (triangle set) output process
601: division reference line
602: division line
701,704: shape surface
702: triangle mesh satisfying the first condition
703: triangle mesh failing to satisfy the first condition
705: triangle mesh satisfying the second condition
706,708: node of triangle mesh
707: triangle mesh failing to satisfy the second condition
801: mesh generation region to be extracted when shape rough division process is performed
802: mesh generation region to be extracted when shape rough division process is not performed
803: mesh deletion position
S92: hexahedral mesh generation process
S93: hexahedral mesh deletion process
S94: mesh generation region data (hexahedral mesh) output process
1000: hexahedral mesh 1001, 1002; minimum distance
1003: mesh to be deleted
1004: hexahedral mesh after deletion
1005, 1006, 1007, 1008: element surface
1101: hexahedral mesh
1102: element side with length set to 4.4 mm
1103: element side with length set to 5.2 mm
1104: element side with length set to 6 mm
1105: mesh which contains element side with length set to 4.4 mm
1106: mesh which contains element side with length set to 4.4 mm
1107: mesh which contains element side with length set to 4.4 mm
1108: hexahedral mesh after correction

## Claims

1. An analytical mesh generation device (100) comprising:
a shape model input unit (102) for inputting a shape model (M) of an analytical subject;
a mesh size input unit (103) for inputting a size of a hexahedral mesh (1000, 1101) to be generated;
a mesh generation region extraction unit (104) for extracting a mesh generation region (MC) for generating the hexahedral mesh (1000, 1101) from the shape model (M) using the mesh size (D4); and
a hexahedral mesh generation unit (105) for generating the hexahedral mesh (1000, 1101) for the extracted mesh generation region.

2. The analytical mesh generation device (100) according to claim 1, wherein the mesh generation region extraction unit (104) includes a unit of generating a polyhedral mesh for the shape model (M), a unit of deleting a mesh with a size smaller than the mesh size (D4) from the generated polyhedral mesh, and a unit of extracting the polyhedral mesh remained after deletion as the mesh generation region (MC).

3. The analytical mesh generation device (100) according to claim 2, wherein the polyhedral mesh generated in the mesh generation region extraction unit (104) is a tetrahedral mesh (MB).

4. The analytical mesh generation device (100) according to claim 2, wherein:
the polyhedral mesh generated in the mesh generation region extraction unit (104) is the hexahedral mesh (1000, 1101); and
the hexahedral mesh generation unit (105) performs degeneration of an element surface (1005, 1006, 1007, 1008) of the extracted hexahedral mesh to improve the size of the hexahedral mesh (1000, 1101).

5. The analytical mesh generation device (100) according to any one of claims 2 to 4, wherein the mesh generation region extraction unit (104) includes a unit of dividing the shape model (M) into a plurality of partial shapes (M1, M2, M3) preliminarily, and a unit of generating the polyhedral mesh for a set of the divided partial shapes (M1, M2, M3).

6. An analytical mesh generation method comprising the steps of:
holding a shape model (M) of an analytical subject and a mesh size (D4) of a hexahedral mesh (1000, 1101) to be generated;
extracting a mesh generation region (MC) for generating the hexahedral mesh (1000, 1101) from the shape model (M) using the mesh size (D4); and
generating the hexahedral mesh (1000, 1101) for the extracted mesh generation region.

7. The analytical mesh generation method according to claim 6, wherein:
a polyhedral mesh is generated for the shape model (M) upon extraction of the mesh generation region (MC);
the mesh with a size smaller than the mesh size (D4) is deleted from the generated polyhedral mesh; and
the polyhedral mesh remained after deletion is extracted as the mesh generation region (MC).

8. The analytical mesh generation method according to claim 6 or 7, wherein a tetrahedral mesh (MB) is used as the polyhedral mesh for extraction of the mesh generation region (MC).

9. The analytical mesh generation method according to claim 7, wherein:
the hexahedral mesh (1000, 1101) is used as the polyhedral mesh for extraction of the mesh generation region (MC); and
a size of the hexahedral mesh (1000, 1101) is improved by performing degradation of an element surface (1005, 1006, 1007, 1008) of the hexahedral mesh (1000, 1101) as the polyhedral mesh remained after deletion.

10. The analytical mesh generation method according to any one of claims 7 to 9, wherein:
the shape model (M) is preliminarily divided into a plurality of partial shapes (M1, M2, M3) upon extraction of the mesh generation region (MC); and
the polyhedral mesh is generated for a set of the divided partial shapes (M1, M2, M3).
